(19) **Europäisches Patentamt European Patent Office Office européen des brevets**

(11) **EP 4 203 362 B1**

(12) **FASCICULE DE BREVET EUROPEEN**

(45) Date de publication et mention
de la délivrance du brevet:
**20.08.2025 Bulletin 2025/34**

(21) Numéro de dépôt: **22215842.0**

(22) Date de dépôt: **22.12.2022**

(51) Classification Internationale des Brevets (IPC):
**H04L 1/00** *(2006.01)*     **H03M 13/25** *(2006.01)*
**H03M 13/33** *(2006.01)*     **H03M 13/13** *(2006.01)*
**H04L 27/10** *(2006.01)*     **H04L 27/02** *(2006.01)*
**H03M 13/00** *(2006.01)*     **H04J 13/00** *(2011.01)*
**H04J 11/00** *(2006.01)*

(52) Classification Coopérative des Brevets (CPC):
**H04L 1/0041; H03M 13/134; H03M 13/251;
H03M 13/33; H04L 1/0057; H04L 27/02;
H04L 27/10;** H04J 11/00; H04J 13/00

(54) **PROCÉDÉS ET DISPOSITIFS DE TRANSMISSION ET DE RÉCEPTION DE MOTS DE CODE CORRECTEUR D ERREUR NON BINAIRE**

**VERFAHREN UND VORRICHTUNGEN ZUM SENDEN UND EMPFANGEN VON NICHTBINÄREN FEHLERKORREKTURCODEWÖRTERN**

**METHODS AND DEVICES FOR TRANSMITTING AND RECEIVING NON-BINARY ERROR CORRECTING CODE WORDS**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **23.12.2021 FR 2114346**

(43) Date de publication de la demande:
**28.06.2023 Bulletin 2023/26**

(73) Titulaires:
• **Commissariat à l'Energie Atomique et aux Energies Alternatives**
**75015 Paris (FR)**
• **Universite De Bretagne Sud**
**56100 Lorient (FR)**

(72) Inventeurs:
• **SAVIN, Valentin**
**38054 GRENOBLE CEDEX 9 (FR)**
• **BOUTILLON, Emmanuel**
**56100 LORIENT (FR)**

(74) Mandataire: **Lavoix**
**2, place d'Estienne d'Orves**
**75441 Paris Cedex 09 (FR)**

(56) Documents cités:
**US-A1- 2010 310 009     US-A1- 2015 003 499**

• **SAIED KASSEM ET AL: "Time-Synchronization of CCSK Short Frames", 2021 17TH INTERNATIONAL CONFERENCE ON WIRELESS AND MOBILE COMPUTING, NETWORKING AND COMMUNICATIONS (WIMOB), IEEE, 11 October 2021 (2021-10-11), pages 307 - 312, XP034027218, DOI: 10.1109/WIMOB52687.2021.9606328**
• **SAVIN VALENTIN: "Non-Binary Polar Codes for Spread-Spectrum Modulations", 2021 11TH INTERNATIONAL SYMPOSIUM ON TOPICS IN CODING (ISTC, IEEE, 30 August 2021 (2021-08-30), pages 1 - 5, XP034018253, DOI: 10.1109/ISTC49272.2021.9594166**

**Description**

La présente invention concerne des procédés de transmission et de réception de mots de code correcteur d'erreur non binaire, et des dispositifs associés.

L'invention se situe dans le domaine de la communication de données par un canal de transmission introduisant un délai inconnu et/ou du bruit.

L'invention trouve des applications dans les transmissions massives de données de charge utile faible, par exemple dans le cadre de la communication massive en réseau par objets connectés (en anglais « massive IoT »).

De manière traditionnelle dans le domaine des systèmes de communications asynchrones, lorsqu'un canal de transmission ajoute un délai inconnu, afin d'assurer la synchronisation au niveau du récepteur, il est connu d'introduire des en-têtes de synchronisation dans les trames de communication. De plus, pour assurer un décodage correct en présence de bruit, il est également connu d'utiliser des codes correcteurs d'erreurs.

La synchronisation par ajout d'en-têtes de synchronisation introduit une augmentation de la quantité des données à transmettre, pour une même charge utile, ce qui consomme à la fois des ressources spectrales et de l'énergie lors de la transmission. Une telle surcharge en termes de quantité de données à transmettre n'est pas acceptable.

On connaît également des systèmes de communications dans lesquels des séquences de synchronisation sont superposées sur des trames de communication, au lieu d'être transmises dans des en-têtes. Cette superposition augmente l'énergie consommée lors de la transmission. De plus, au niveau du récepteur, des opérations séparées de synchronisation, puis de décodage sont à mettre en œuvre, ce qui augmente la complexité des récepteurs.

Il est souhaitable de simplifier le décodage tout en limitant la quantité de données à transmettre pour permettre une synchronisation dans le cadre des communications asynchrones.

En outre, il est connu d'utiliser une modulation à décalage de code cyclique (en anglais, CCSK pour « Cyclic Code-Shift Key ») pour étaler le spectre d'un signal émis, afin d'obtenir une meilleure robustesse au bruit. Le document US2015/003499 A1 décrit un procédé de transmission de mots de code correcteur d'erreur non binaire avec modulation CCSK.

L'invention a pour but de répondre à cette exigence, en proposant une modification d'une modulation à décalage de code cyclique, qui permet avantageusement de réaliser la détection de présence d'un message, et selon des modes de réalisation particuliers, de réaliser conjointement la synchronisation et le décodage correcteur d'erreur après réception.

A cet effet, l'invention propose, selon un aspect, un procédé de transmission de symboles de mots de code correcteur d'erreur non binaire à travers un canal de transmission, chaque symbole de mot de code comprenant p bits et faisant partie d'un corps fini $GF_q$ à $q=2^p$ éléments, le procédé comportant :

- une première modulation à étalement de spectre associant à chaque symbole de mot de code de p bits une séquence de bribes,
- une deuxième modulation pour moduler au moins une porteuse avec les séquences associées aux mots de code, par modulation de phase ou d'amplitude, permettant d'obtenir au moins une porteuse modulée,
- une transmission de ladite au moins une porteuse modulée formant un signal à travers ledit canal de transmission.

Le procédé est tel que la première modulation met en œuvre un ensemble de q séquences comprenant q-1 séquences de q-1 bribes, chaque séquence étant obtenue par décalage circulaire d'une séquence pseudo-aléatoire de base, et une séquence partiellement invariante, formée de q-1 bribes et invariante par un sous-ensemble prédéterminé de décalages circulaires. La première modulation met en œuvre en outre une association entre chaque symbole de mot de code et une séquence de l'ensemble de séquences dans laquelle, ledit corps fini $GF_q$ ayant un élément primitif non nul, le symbole zéro est associé à ladite séquence partiellement invariante et un symbole égal à une puissance j de l'élément primitif, j étant un entier compris entre 0 et q-2, est associé à une séquence pseudo-aléatoire déterminée par j décalages circulaires de la séquence pseudo-aléatoire de base.

Le procédé de transmission de symboles de mots de code correcteur d'erreur non binaire à travers un canal de transmission selon l'invention peut également présenter une ou plusieurs des caractéristiques ci-dessous, prises indépendamment ou selon toutes les combinaisons techniquement envisageables.

La séquence partiellement invariante est une séquence constante formée de q-1 bribes de même valeur.

Le procédé comporte en outre, préalablement à l'application d'un code correcteur d'erreur non binaire, une formation d'un message de K symboles de $GF_q$, auquel est appliqué le codage correcteur d'erreur non binaire pour générer un mot de code, le message étant formé de sorte qu'un symbole dit symbole d'ancrage, de valeur appartenant à un sous-ensemble prédéterminé de $GF_q$, soit placé à une position prédéterminée dans le message ou dans ledit mot de code.

Le sous-ensemble prédéterminé de $GF_q$ comprend une seule valeur non nulle prédéterminée, et le symbole d'ancrage prend ladite valeur non nulle prédéterminée.

Dans l'étape de formation du message, ledit symbole d'ancrage est placé à ladite position prédéterminée dans le message.

La formation du message comprend une détermination d'un symbole dudit message en fonction de K-1 autres symboles du message, le mot de code obtenu après codage comprenant ledit symbole d'ancrage à ladite position prédéterminée.

La première modulation comporte une génération de la séquence pseudo-aléatoire de base par un registre à décalage à rétroaction linéaire de longueur maximale.

La deuxième modulation est une modulation de phase ou d'amplitude de la porteuse.

La deuxième modulation utilisée pour la séquence partiellement invariante est différente de la deuxième modulation utilisée par les séquences obtenues par décalage circulaire de la séquence pseudo-aléatoire de base.

La deuxième modulation comporte une absence d'onde porteuse pour la séquence partiellement invariante et une modulation de phase pour les séquences obtenues par décalage circulaire de la séquence pseudo-aléatoire de base.

Selon un autre aspect, l'invention concerne un procédé de réception d'un signal reçu, le signal reçu étant transmis par un procédé de transmission tel que brièvement décrit ci-dessus, le signal transmis comportant des symboles de mot de code correcteur d'erreur transmis. Le procédé de réception comporte des étapes de :

- démodulation du signal reçu, permettant d'obtenir une estimation des symboles codés transmis à partir du signal reçu,
- un décodage et synchronisation conjoints, comprenant :

  - un décodage pour déterminer un mot décodé et/ou un message décodé correspondant à partir des estimations de symboles codés fournies par l'étape de démodulation, ledit mot décodé fournissant une estimation du mot de code transmis multiplié par l'élément primitif du corps fini $GF_q$ élevé à une puissance égale à un décalage de synchronisation,
  - une estimation dudit décalage de synchronisation à partir d'un symbole d'ancrage à une position prédéterminée dans le mot décodé ou dans le message décodé correspondant.

Le procédé de réception selon l'invention peut également présenter une ou plusieurs des caractéristiques ci-dessous, prises indépendamment ou selon toutes les combinaisons techniquement envisageables.

Le procédé de réception comprend en outre une estimation du mot de code transmis en divisant les symboles du mot décodé et/ou du message décodé par l'élément primitif du corps fini élevé à la puissance égale au décalage de synchronisation estimé.

Le procédé de réception comprend en outre, lorsque l'estimation du mot de code transmis ne permet pas d'obtenir un mot de code, une synchronisation en appliquant le décalage de synchronisation estimé et une itération des étapes de décodage, d'estimation du décalage de synchronisation jusqu'à ce qu'un critère d'arrêt soit vérifié.

Les étapes de démodulation et de décodage et synchronisation conjoints sont répétées périodiquement, en décalant le signal reçu d'un nombre de bribes prédéterminé.

Selon un autre aspect, l'invention concerne un dispositif de transmission de symboles de mot de code correcteur d'erreur non binaire à travers un canal de transmission, chaque symbole de mot de code comprenant p bits et faisant partie d'un corps fini $GF_q$ à $q=2^p$ éléments. Le dispositif de transmission est configuré pour mettre en œuvre :

- un module de première modulation à étalement de spectre associant à chaque symbole de mot de code de p bits une séquence de bribes,
- un module de deuxième modulation configuré pour moduler au moins une porteuse avec les séquences associées aux mots de code, par modulation de phase ou d'amplitude, permettant d'obtenir au moins une porteuse modulée,
- un module de transmission de ladite au moins une porteuse modulée formant un signal à travers ledit canal de transmission.

Ce dispositif de transmission est tel que le module de première modulation est configuré pour mettre en œuvre un ensemble de q séquences comprenant q-1 séquences de q-1 bribes, chaque séquence étant obtenue par décalage circulaire d'une séquence pseudo-aléatoire de base ($R_0$), et une séquence partiellement invariante, formée de q-1 bribes et invariante par un sous-ensemble prédéterminé de décalages circulaires. Le module de première modulation est en outre configuré pour mettre en œuvre une association entre chaque symbole de mot de code et une séquence de l'ensemble de séquences dans laquelle, ledit corps fini $GF_q$ ayant un élément primitif non nul, le symbole zéro est associé à la séquence partiellement invariante et un symbole égal à une puissance j de l'élément primitif, j étant un entier compris entre 0 et q-2, est associé à une séquence pseudo-aléatoire déterminée par j décalages circulaires de la séquence pseudo-aléatoire de base.

Le dispositif de transmission est configuré pour mettre en œuvre toutes les étapes du procédé de transmission brièvement décrit ci-dessus, selon toutes ses variantes de mise en œuvre.

**EP 4 203 362 B1**

Selon un autre aspect, l'invention concerne un dispositif de réception d'un signal reçu, ledit signal reçu étant issu d'un signal transmis par un dispositif de transmission tel que brièvement décrit ci-dessus, ledit signal transmis comportant des symboles de mot de code correcteur d'erreur transmis. Le dispositif de réception est configuré pour mettre en œuvre :

- un module de démodulation du signal reçu, permettant d'obtenir une estimation des symboles codés transmis à partir du signal reçu,
- un module de décodage et synchronisation conjoints, comprenant :

  - un module de décodage pour déterminer un mot décodé et/ou un message décodé correspondant à partir des estimations de symboles codés fournies par l'étape de démodulation, ledit mot décodé fournissant une estimation du mot de code transmis multiplié par l'élément primitif du corps fini $GF_q$ élevé à une puissance égale à un décalage de synchronisation,
  - un module d'estimation dudit décalage de synchronisation à partir d'un symbole d'ancrage à une position prédéterminée dans le mot décodé ou dans le message décodé correspondant.

Le dispositif de réception est configuré pour mettre en œuvre toutes les étapes du procédé de réception brièvement décrit ci-dessus, selon toutes ses variantes de mise en œuvre.

D'autres caractéristiques et avantages de l'invention ressortiront de la description qui en est donnée ci-dessous, à titre indicatif et nullement limitatif, en référence aux figures annexées, parmi lesquelles :

[Fig 1] la figure 1 représente schématiquement un système de communication asynchrone selon un mode de réalisation ;
[Fig 2] la figure 2 représente schématiquement un dispositif de transmission selon un mode de réalisation ;
[Fig 3] la figure 3 représente schématiquement un dispositif de réception selon un mode de réalisation ;
[Fig 4] la figure 4 est un organigramme des principales étapes d'un procédé de transmission selon un mode de réalisation ;
[Fig 5] la figure 5 est un organigramme des principales étapes d'un procédé de réception selon un mode de réalisation ;
[Fig 6] la figure 6 est un graphe de courbes illustrant le taux d'erreur par trame de réception pour plusieurs exemples de mise en œuvre.

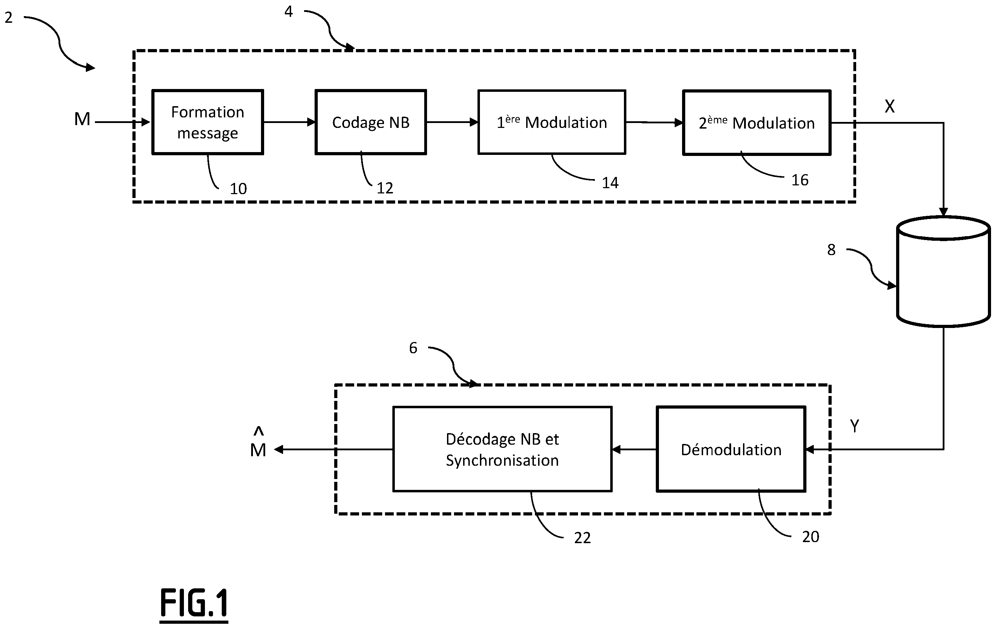

La **figure** 1 illustre un système de communication asynchrone 2 adapté pour mettre en œuvre l'invention, appelé plus simplement système de communication par la suite.

Le système de communication 2 comporte un dispositif de transmission 4 et un dispositif de réception 6. Un message M est traité et transmis, sous forme de signal modulé par des porteuses, référencé X, par le dispositif de transmission 4, via un canal de transmission 8 représenté schématiquement à la figure 1, vers le dispositif de réception 6. Le dispositif de réception 6 reçoit et traite un signal reçu Y, afin d'obtenir un message décodé $\hat{M}$.

Le message M contient des données utiles à transmettre, sous forme d'un ensemble de bits appelés bits source.

Le canal de transmission 8 ajoute un délai inconnu, appelé par la suite délai de synchronisation, ainsi qu'un bruit de canal.

Dans l'exemple de la figure 1, le dispositif de transmission 4 comporte un module de codage non binaire 10, qui applique un codage correcteur d'erreur linéaire non binaire au message à transmettre.

L'invention s'applique avec tout code correcteur d'erreur non binaire et linéaire, par exemple un des codes correcteurs suivants : code de parité à faible densité LDPC (pour « Low Density Parity Check »), Reed-Solomon, Turbo-code ou code polaire.

Les codes correcteurs de ce type sont construits sur un corps de Galois non binaire à q éléments (ou de cardinalité q), noté $GF_q$, q étant une puissance d'un nombre premier, et de préférence une puissance de 2, par exemple $q=2^p$ pour représenter des symboles à p bits.

De manière connue, un tel corps de Galois comprend l'élément nul 0 et q-1 puissances successives d'un élément primitif $\alpha$.

En d'autres termes, les éléments du corps $GF_q$ sont définis par :

[MATH 1]

$$GF_q = \{0, \alpha^0, \alpha^1, ..., \alpha^{q-2}\}$$

Un ensemble de $(K-1)\times p$ bits source, correspondant à K-1 symboles source de p bits chacun est tout d'abord complété par p bits connus, correspondant à un symbole non nul de $GF_q$, de valeur connue, également appelé symbole

4

d'ancrage, de façon à générer un message source de K symboles exactement. Le message ainsi étendu est dénoté par :

[MATH 2]

$$M = (m_1, m_2, ..., m_K) \in GF_q^K$$

Par exemple, si le symbole d'ancrage prend la valeur $\alpha^0 = 1$ et qu'il est placé à la première position du message M, on obtient :

[MATH 3]

$$M = (\alpha^0, m_2, ..., m_K) \in GF_q^K$$

Bien entendu, toute autre valeur prédéterminée non nulle $\alpha^i \neq 0$, et toute autre position prédéterminée d'indice $j$, $1 \leq j \leq K$, peuvent être choisies :

[MATH 4]

$$M = (m_1, ..., m_{j-1}, \alpha^i, m_{j+1}, ..., m_K) \in GF_q^K$$

Par simplicité et sans perte de généralité, on pourra donc supposer que $m_1 \neq 0$ est le symbole d'ancrage, connu à la fois par l'émetteur et par le récepteur.

Dans ce cas, le symbole d'ancrage prend sa valeur dans un sous-ensemble prédéterminé de $GF_q$, ce sous-ensemble étant réduit à une seule valeur non nulle prédéterminée.

Le message étendu de taille K symboles est alors transformé par le codage correcteur d'erreur en un mot de code $C$ de N symboles (soit N×p bits codés), le nombre N étant supérieur au nombre K.

[MATH 5]

$$C = (c_1, ..., c_N) \in GF_q^N$$

Si l'opération de codage est systématique, c'est-à-dire que l'ensemble des K symboles du message $M$ se retrouvent en intégralité dans le mot de code $C$ à des positions connues, alors le symbole d'ancrage de valeur prédéterminée $m_1$ se retrouvera à une position connue de $C$.

Dans ce cas, par simplicité et sans perte de généralité, on supposera que $m_1$ se retrouve à la première position dans $C$, c'est-à-dire $c_1 = m_1$, ce qui en fait un symbole connu à la fois par l'émetteur et par le récepteur.

A noter que si l'opération de codage n'est pas systématique, le mot de code $C$ ne contient pas nécessairement de symbole d'ancrage de valeur prédéterminée.

Néanmoins, dans un mode de réalisation alternatif, au lieu d'attribuer une valeur prédéterminée à un symbole du message $M$ (symbole d'ancrage dans le message), il est possible d'attribuer une valeur prédéterminée à un symbole du mot de code $C$.

Pour cela, il suffit de considérer le fait que tout symbole du mot du code $C$ peut s'exprimer comme une combinaison linéaire des symboles du message $M$. Par exemple, considérant le premier symbole de $C$ :

[MATH 6]

$$c_1 = h_1 m_1 + h_2 m_2 + \cdots + h_K m_K$$

où les coefficients $h_1, h_2, ..., h_K \in GF_q$, avec au moins un coefficient non-nul, et les opérations de multiplication et d'addition dans la formule ci-dessus s'effectuent dans $GF_q$. Ainsi, en supposant sans perte de généralité que $h_1 \neq 0$, on pourra attribuer une valeur prédéterminée au symbole $c_1$, par exemple $c_1 = \alpha^0$, simplement en déterminant la valeur du symbole $m_1$ à partir des valeurs des symboles $m_2, ..., m_K$ par la formule :

[MATH 7]

$$m_1 = h_1^{-1}(\alpha^0 - h_2 m_2 \cdots - h_K m_K)$$

On obtient ainsi $c_1 = \alpha^0$, ce qui en fait un symbole d'ancrage de valeur prédéterminée, connu à la fois par l'émetteur et par le récepteur.

Le présente invention s'applique pour les deux modes de réalisation ci-dessus : aussi bien pour le premier mode de réalisation lorsque le symbole d'ancrage est un symbole du message *M*, que pour le deuxième mode de réalisation, lorsque le symbole d'ancrage est un symbole du mot de code *C*. A noter que les deux modes de réalisation sont obtenus par une formation spécifique du message M.

Le dispositif de transmission comporte également un module 14 de première modulation, configuré pour appliquer une première modulation et un module 16 de deuxième modulation configuré pour appliquer une deuxième modulation.

La première modulation appliquée par le module 14 est une modulation à étalement de spectre. Plus particulièrement, le module 14 de première modulation met en œuvre une variante modifiée de la modulation à décalage de code cyclique CCSK.

La modulation CCSK classique consiste à associer une séquence de q bribes (en anglais « chips ») à chaque symbole d'un ensemble de q symboles, numérotés de 0 à q-1. L'espace des séquences de bribes est constitué de séquences $P_0$ à $P_{q-1}$, où $P_0$ est une séquence pseudo-aléatoire formée de q bits, et chaque séquence $P_j$ est obtenue par décalage circulaire de j positions, dans un sens prédéterminé, de la séquence $P_0$.

A titre d'exemple numérique, pour q=8 et p=3, la table 1 ci-dessous illustre l'association ou mise en correspondance (en anglais « mapping ») entre chaque symbole et chaque séquence, obtenue par décalage circulaire vers la gauche d'une séquence $P_0$=(1,1,1,0,1,0,0,0) :

[TABLE 1]

| | |
|---|---|
| 0 | 1 1 1 0 1 0 0 0 |
| 1 | 1 1 0 1 0 0 0 1 |
| 2 | 1 0 1 0 0 0 1 1 |
| 3 | 0 1 0 0 0 1 1 1 |
| 4 | 1 0 0 0 1 1 1 0 |
| 5 | 0 0 0 1 1 1 0 1 |
| 6 | 0 0 1 1 1 0 1 0 |
| 7 | 0 1 1 1 0 1 0 0 |

Le sens du décalage circulaire est choisi par convention.

La première modulation selon l'invention met en œuvre un ensemble de q séquences $\{Z,R_0,...,R_{q-2}\}$ comprenant q-1 séquences de q-1 bribes, chaque séquence étant obtenue par décalage circulaire d'une séquence pseudo-aléatoire de base $R_0$, et une séquence partiellement invariante Z , qui est dans ce mode de réalisation une séquence constante (i.e. invariante par tout décalage circulaire dans ce cas) formée de q-1 bribes de même valeur.

De préférence, la séquence pseudo-aléatoire de base $R_0$ est générée par un registre à décalage à rétroaction linéaire de longueur maximale ou par une séquence appelée « Constant amplitude zero autocorrelation waveform (CAZAC) ».

En utilisant une formulation mathématique, la séquence pseudo-aléatoire de base $R_0$ s'écrit :

[MATH 8]

$$R_0 = (R_0(0), R_0(1), ..., R_0(q-2))$$

Où $R_0(i) \in \{0,1\}$, $\forall i = 0,1, ..., q$ - 2

L'ensemble des séquences $R_1$ à $R_{q-2}$ est défini par décalage circulaire, dans un sens prédéterminé, de la séquence $R_0$. Ainsi, toute séquence $R_u$, $\forall u = 0, ..., q$ - 2 , s'écrit :

[MATH 9]

$$R_u(i) = R_0(i + u \, mod(q - 1)), \forall i = 0, ..., q - 1,$$

La séquence constante Z comporte q-1 bribes de même valeurs, et est notée : $Z = (z,z,..,z)$.

Par exemple, on pourra considérer z=0 ou z=1. Cependant, on pourra également considérer z comme une valeur symbolique (plutôt qu'une valeur numérique), de manière à pouvoir la distinguer des bribes 0 et 1 composant les séquences $R_0,...,R_{q-2}$. Cela permet de distinguer, dans le module de deuxième modulation 16, entre la modulation utilisée pour la séquence Z et celle utilisée pour les séquences $R_0,...,R_{q-2}$.

Avantageusement, la séquence constante Z est invariante pour tout décalage circulaire.

L'association d'un symbole de $GF_q$ à une séquence de l'ensemble des séquences $\{Z, R_0, R_1, ... , R_{q-2}\}$ est définie par une fonction $\mu()$ de mise en correspondance définie de la manière suivante :

[MATH 10]

$$\mu(0) = Z$$
$$\mu(\alpha^u) = R_u, \forall k = 0, ..., q - 2$$

Ainsi, tous les symboles $c_u$ du mot de code sont associés à une séquence de q-1 bribes de l'ensemble de séquences défini ci-dessus.

La fonction $\mu()$ définit un schéma de mise en correspondance.

A titre d'exemple numérique, pour q=8 et p=3, la table 2 ci-dessous illustre l'association selon le schéma de mise en correspondance défini ci-dessus, avec la séquence de base $R_0$=(1,1,1,0,1,0,0) :

[TABLE 2]

| 0 | z z z z z z z |
|---|---|
| $\alpha^0$ | 1 1 1 0 1 0 0 |
| $\alpha^1$ | 1 1 0 1 0 0 1 |
| $\alpha^2$ | 1 0 1 0 0 1 1 |
| $\alpha^3$ | 0 1 0 0 1 1 1 |
| $\alpha^4$ | 1 0 0 1 1 1 0 |
| $\alpha^5$ | 0 0 1 1 1 0 1 |
| $\alpha^6$ | 0 1 1 1 0 1 0 |

Cette association est appelée association $GF_q$-covariante.

La propriété suivante, dite propriété de covariance, est vérifiée pour cette modulation CCSK modifiée : lorsqu'un symbole c de $GF_q$ est associé par le schéma de mise correspondance défini par u(), i.e. $\mu(c) = S$, la séquence S' obtenue par un décalage circulaire de k positions, notée $S' = k \circlearrowleft S$ est la séquence de bribes associée à $\alpha^k c$. En d'autres termes :

[MATH 11]

$$\mu(\alpha^k c) = k \circlearrowleft S$$

De manière équivalente, en notant $\mu^{-1}()$ l'association inverse, permettant d'associer une séquence de bribes à un symbole, la relation suivante est vérifiée :

[MATH 12]

$$\mu^{-1}(k \circlearrowleft S) = \alpha^k c$$

La deuxième modulation, mise en œuvre par le module 16 de deuxième modulation, est une modulation de phase ou une modulation d'amplitude, par exemple une modulation BPSK (pour « Binary Phase Shift-Key ») ou une modulation OOK (pour « On Off Keying »), cette dernière étant également connue sous le nom de modulation « tout ou rien ».

Dans un mode de réalisation, les séquences $R_u$ obtenues par décalage circulaire de la séquence $R_0$ sont modulées en utilisant la modulation de phase, de préférence la modulation de phase BPSK, et la séquence constante Z est modulée selon une modulation différente.

Selon un mode de réalisation particulier, la deuxième modulation comporte une absence d'onde porteuse pour la séquence constante et une modulation de phase à 2 états ou BPSK (pour « Binary Phase Shift Keying ») pour les séquences obtenues par décalage circulaire de la séquence pseudo-aléatoire de base.

Les porteuses modulées forment un signal X transmis via le canal de transmission.

Le dispositif de réception 6 comporte un module 20 de démodulation et un module 22 de décodage et synchronisation conjoints, le décodage étant un décodage correcteur non binaire.

Avantageusement, notamment grâce à l'application de la première modulation telle que décrite ci-dessus, le dispositif récepteur est adapté pour réaliser conjointement le décodage correcteur d'erreur et la synchronisation, comme cela sera décrit plus en détail ci-après.

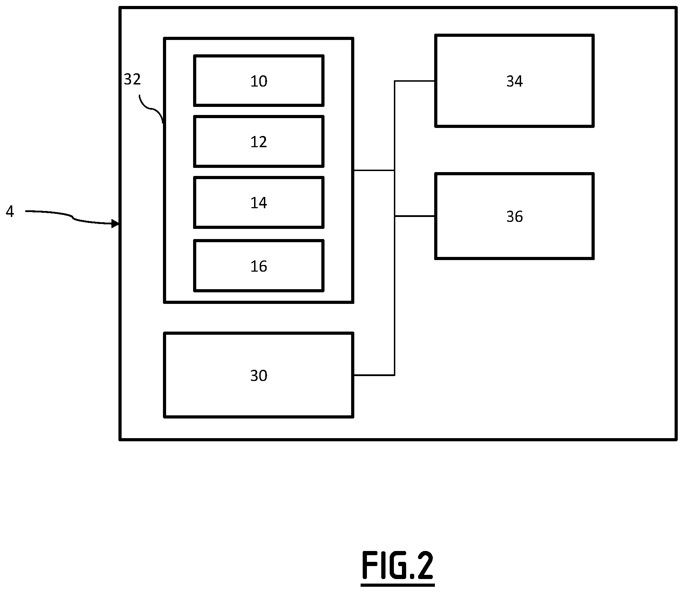

La **figure 2** représente schématiquement un dispositif de transmission 4 selon un mode de réalisation. Le dispositif de transmission 4 est un dispositif électronique programmable, typiquement un ordinateur, et comprend une unité centrale de calcul (CPU) 30, une mémoire électronique 32, une interface de communication 34 et une interface homme-machine 36. Les éléments 30, 32, 34, 36 sont adaptés à communiquer via un bus informatique.

L'unité centrale de calcul 30 comprend un ou plusieurs processeurs, aptes à exécuter des instructions de programme d'ordinateur, mémorisés par la mémoire électronique 32, lorsque le dispositif 4 est mis sous tension.

L'unité de mémoire électronique est configurée pour mémoriser un module 10 de formation d'un message de K symboles non-binaires , un module 12 de codage non binaire, un module 14 de première modulation et un module 16 de deuxième modulation.

Dans un mode de réalisation, les modules 10, 12, 14, 16 sont réalisés sous forme de code logiciel, et forment un programme d'ordinateur, comportant des instructions logicielles qui, lorsqu'elles sont mises en œuvre par le dispositif électronique programmable, mettent en œuvre un procédé de transmission de symboles de mot de code correcteur d'erreur non binaire selon l'invention.

En variante non représentée, les modules 10, 12, 14, 16 sont réalisés chacun sous forme d'un composant logique programmable, tel qu'un FPGA (de l'anglais *Field Programmable Gate Array*), ou un GPGPU (de l'anglais *General-purpose processing on graphics processing*), ou encore sous forme d'un circuit intégré dédié, tel qu'un ASIC (de l'anglais *Application Specific Integrated Circuit*).

Le programme d'ordinateur mettant en œuvre le procédé de transmission de symboles de mot de code correcteur d'erreur non binaire est en outre apte à être enregistré sur un support, non représenté, lisible par ordinateur. Le support lisible par ordinateur est par exemple, un médium apte à mémoriser les instructions électroniques et à être couplé à un bus d'un système informatique. A titre d'exemple, le support lisible est un disque optique, un disque magnéto-optique, une mémoire ROM, une mémoire RAM, tout type de mémoire non-volatile (par exemple EPROM, EEPROM, FLASH, NVRAM), une carte magnétique ou une carte optique.

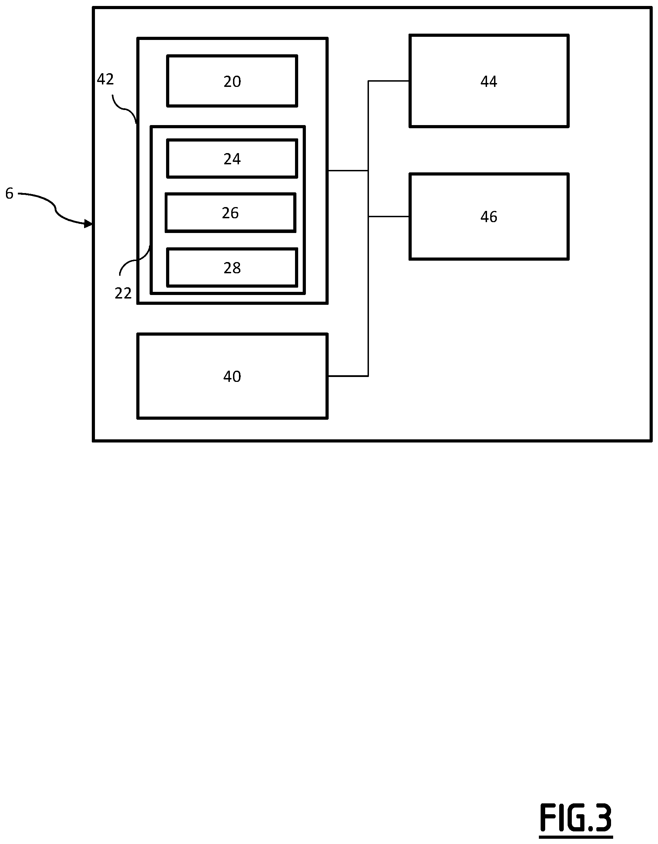

La **figure 3** représente schématiquement un dispositif de réception 6 selon un mode de réalisation. Le dispositif de réception 6 est un dispositif électronique programmable, typiquement un ordinateur, et comprend une unité centrale de calcul (CPU) 40, une mémoire électronique 42, une interface de communication 44 et une interface homme-machine 66. Les éléments 40, 42, 44, 46 sont adaptés à communiquer via un bus informatique.

L'unité centrale de calcul 40 comprend un ou plusieurs processeurs, aptes à exécuter des instructions de programme d'ordinateur, mémorisés par la mémoire électronique 42, lorsque le dispositif 6 est mis sous tension.

L'unité de mémoire électronique est configurée pour mémoriser un module 20 de démodulation et un module 22 de décodage et synchronisation conjoints. Le module 22 comprend un module 24 de décodage de code correcteur d'erreur non binaire, un module 26 d'estimation d'un décalage de synchronisation et un module 28 de calcul du mot de code transmis et du message correspondant en appliquant le décalage de synchronisation estimé.

Dans un mode de réalisation, les modules 20, 24, 26, 28 sont réalisés sous forme de code logiciel, et forment un programme d'ordinateur, comportant des instructions logicielles qui, lorsqu'elles sont mises en œuvre par le dispositif électronique programmable, mettent en œuvre un procédé de réception selon l'invention.

En variante non représentée, les modules 20, 24, 26, 28 sont réalisés chacun sous forme d'un composant logique programmable, tel qu'un FPGA (de l'anglais *Field Programmable Gate Array*), ou un GPGPU (de l'anglais *General-purpose processing on graphics processing*), ou encore sous forme d'un circuit intégré dédié, tel qu'un ASIC (de l'anglais *Application Specific Integrated Circuit*).

Le programme d'ordinateur mettant en œuvre le procédé de réception est en outre apte à être enregistré sur un support, non représenté, lisible par ordinateur. Le support lisible par ordinateur est par exemple, un médium apte à mémoriser les instructions électroniques et à être couplé à un bus d'un système informatique. A titre d'exemple, le support lisible est un disque optique, un disque magnéto-optique, une mémoire ROM, une mémoire RAM, tout type de mémoire non-volatile (par exemple EPROM, EEPROM, FLASH, NVRAM), une carte magnétique ou une carte optique.

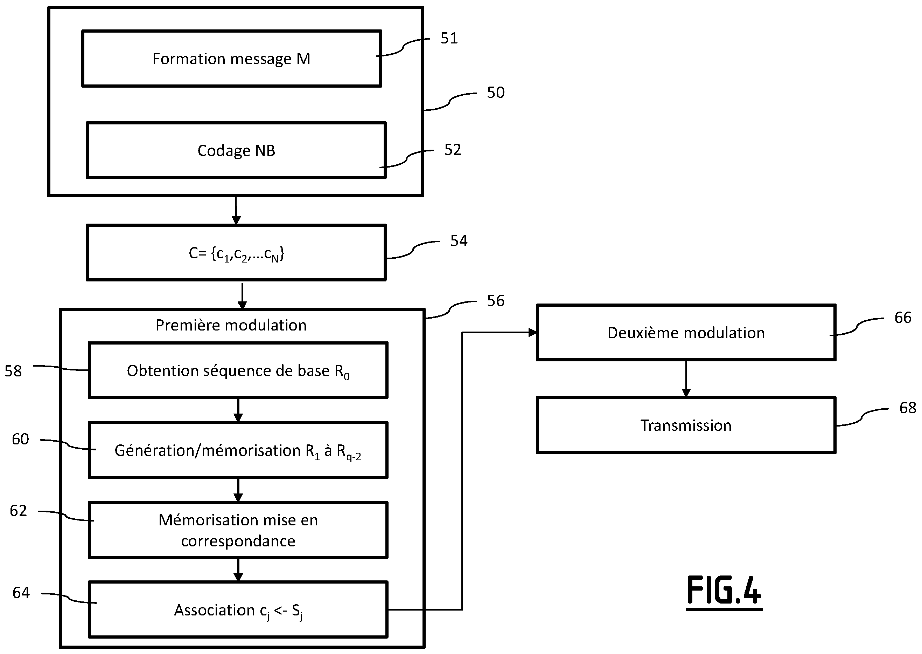

La **figure 4** un organigramme des principales étapes d'un procédé de transmission selon un mode de réalisation.

Le procédé comporte une étape 50 d'obtention de symboles de mots de code d'erreur non binaire à transmettre.

Dans un mode de réalisation, l'étape 50 comporte des sous-étapes 51 de formation du message M à traiter et transmettre, selon la description faite ci-dessus, et une sous-étape 52 de codage par un code correcteur d'erreur non binaire choisi permettant d'obtenir des symboles codés à p bits, p étant un nombre entier.

Deux modes de réalisation distincts de la sous-étape 51 de formation du message M sont envisagés.

Dans un premier mode de réalisation le message M comprend K-1 symboles de données utiles à transmettre, ainsi qu'un symbole d'ancrage de valeur prédéterminée non-nulle, placé à une position prédéterminée dans le message (par exemple $m_1 = \alpha^0$).

Dans un deuxième mode de réalisation le message M comprend K-1 symboles de données utiles à transmettre, ainsi qu'un symbole dont la valeur est déterminée en fonction des K-1 symboles de données utiles, de façon à ce qu'un symbole d'ancrage placé à une position prédéterminée dans le mot de code prenne une valeur prédéterminée non-nulle (par exemple $m_1 = h_1^{-1}(\alpha^0 - h_2 m_2 \cdots - h_K m_K)$, de manière à ce que après l'étape de codage 52, on obtienne $c_1 = \alpha^0$)

Le code correcteur d'erreur non binaire appliqué à la sous-étape 52 est par exemple un code de parité à faible densité non binaire NB-LDPC.

Les symboles obtenus font partie d'un corps de Galois $GF_q$ à $q=2^p$ éléments.

A l'issue de l'étape 50 est obtenu un mot de code correcteur : $C = \{c_1, ..., c_N\}$ (référencé 54).

Le procédé comprend en outre une étape 56 d'application d'une première modulation, qui est une modulation CCSK modifiée telle que décrite ci-dessus, permettant d'associer chaque symbole à une séquence de q-1 bribes parmi l'ensemble des séquences $\{Z, R_0, R_1, ... , R_{q-2}\}$ comportant la séquence constante Z et des séquences de bribes $R_u$, chaque séquence $R_u$ étant obtenue par décalage circulaire d'une séquence pseudo-aléatoire de base $R_0$ de q-1 bribes.

Optionnellement, l'étape 56 de première modulation comprend des sous-étapes 58 à 62 telles que décrites ci-dessous.

L'étape 56 comprend alors une sous-étape 58 d'obtention de la séquence pseudo-aléatoire de base $R_0$.

De préférence, cette séquence pseudo-aléatoire de base est générée par un générateur et mémorisée. Par exemple, la séquence est générée par un registre à décalage à rétroaction linéaire de longueur maximale.

L'étape 56 comprend également une sous-étape 60 de génération et de mémorisation des séquences $R_1$ à $R_{q-2}$.

L'étape 56 comprend également une sous étape 62 de mémorisation de la fonction $\mu()$ de mise en correspondance telle que définie par la formule [MATH 10].

En variante, la génération de l'ensemble de séquences $R_0$ à $R_{q-2}$ et la mémorisation de la mise en correspondance sont effectuées préalablement à la mise en œuvre du procédé.

Enfin, l'étape 58 comprend une étape 64 d'association d'une séquence de bribes à chaque symbole de mot de code, dans laquelle, pour chaque symbole $c_j$ du mot de code C, la séquence de bribes Sj associée est déterminée par application de la fonction de mise en correspondance :

[MATH 13]

$$S_j = \mu(c_j)$$

Le procédé comprend en outre une étape 66 d'application d'une deuxième modulation, par exemple une modulation de phase ou une modulation d'amplitude.

Dans un mode de réalisation, pour chaque séquence $S_j=R_i$, en d'autres termes si la séquence $S_j$ est une des séquences de bribes obtenues à partir de la séquence pseudo-aléatoire de base $R_0$, alors la modulation BPSK est appliquée, ainsi que pour la séquence constante Z.

Selon une variante, différemment de la modulation appliquée aux séquences de bribes obtenues par décalage circulaire de la séquence pseudo-aléatoire de base, la séquence constante est modulée à « 0 ». En d'autres termes, il n'y a pas de transmission (e.g. absence de d'onde porteuse) pendant la durée de la séquence constante Z. Avantageusement, la puissance de transmission est diminuée.

La deuxième modulation 66 est suivie d'une étape de transmission 68 des porteuses successives formant un signal X.

Avantageusement, grâce à la propriété de covariance définie ci-dessus, dans un cas « idéal », si le canal de transmission 8 introduit une désynchronisation circulaire, c'est-à-dire, si les séquences de bribes $(S_1,...,S_N)$, associées aux symboles $(c_1,..., c_N)$ d'un mot de code C, sont reçues au décodeur sous la forme $(k \circlearrowleft S_1, ... , k \circlearrowleft S_N)$, la mise en œuvre de l'association inverse $\mu^{-1}()$ permet d'obtenir directement le mot de code $C' = (\alpha^k c_1, ... , \alpha^k c_N)$.

Le cas idéal décrit ci-dessus est purement théorique.

En pratique, le canal de transmission 8 introduit une désynchronisation qui se traduit par une désynchronisation « quasi-circulaire » des séquences $(S_1,...,S_N)$. En effet, en cas de désynchronisation de k bribes, uniquement q-1-k bribes d'une séquence reçue correspondent à un décalage circulaire de la séquence de bribes transmise, les k bribes restantes étant en fait des bribes appartenant à une séquence de bribes contiguë. Cela permet de considérer la séquence reçue comme une version bruitée de la séquence ($k \circlearrowleft S_1, \ldots, k \circlearrowleft S_N$).

Ainsi, en décodant la séquence reçue on obtient une estimation du mot de code $C' = (\alpha^k c_1, \ldots, \alpha^k c_N)$, et donc du message correspondant $M' = (\alpha^k m_1, \ldots, \alpha^k m_K)$.

La connaissance d'un symbole d'ancrage de valeur prédéterminée, que ce soit un symbole du mot de code transmis C ou du message correspondant M, permet alors en outre de déterminer le décalage de synchronisation k subi par le signal transmis, comme il sera expliqué plus bas.

Notons aussi que, outre la correction du décalage de synchronisation, l'opération de décodage permet également de corriger les erreurs de transmission dues au bruit présent sur le canal de transmission.

Ainsi, l'invention proposée permet de réaliser conjointement la synchronisation et le décodage correcteur d'erreur.

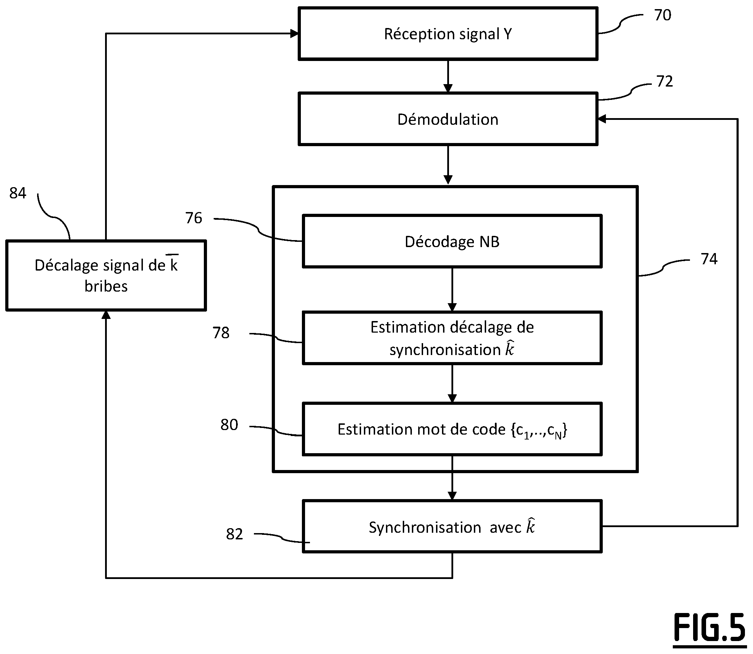

La **figure 5** un organigramme des principales étapes d'un procédé de réception selon un mode de réalisation.

Le procédé de réception comporte une étape 70 de réception d'un signal Y, qui correspond au signal X transmis par le procédé de transmission, affecté d'un décalage de synchronisation inconnu et corrompu par un bruit, par exemple modélisable par un bruit blanc Gaussien.

Le procédé de réception comporte une étape 72 de démodulation permettant d'obtenir une estimation des symboles codés transmis, à partir du signal Y reçu, sans estimation de décalage de synchronisation.

Selon divers modes de réalisation possibles, l'estimation peut prendre soit la forme d'une décision dure, c.-à-d. qu'on détermine pour chaque symbole du mot de code la valeur dans $GF_q$ la plus probable selon le signal reçu, soit la forme d'une décision souple, c.-à-d. qu'on détermine pour chaque symbole du mot de code une distribution de probabilité sur $GF_q$, ou de manière équivalente des valeurs de vraisemblance logarithmique pour chaque élément de $GF_q$, selon le signal reçu.

Dans un mode de réalisation, la démodulation 72 applique une méthode dite de logarithme de rapport de vraisemblance (en anglais LLR pour « Log Likelihood Ratio »), d'ordre q (en anglais « q-ary LLR »), connue de l'homme du métier.

Dans un mode de réalisation, le calcul est effectué en utilisant des opérations de transformation de Fourier discrète et inverse, mises en œuvre par exemple par des transformations de Fourier rapides, respectivement FFT (pour « Fast Fourier Transform ») et IFFT (pour « Inverse Fast Fourier Transform »).

Le procédé comporte ensuite une étape 74 de décodage et synchronisation conjoints, réalisant conjointement le décodage des mots de code transmis et l'estimation de décalage de synchronisation k.

L'étape 74 comporte une sous-étape 76 de décodage par application du décodage correcteur d'erreur non binaire correspondant au codage correcteur d'erreur non binaire appliqué dans le procédé de transmission.

A l'issue de l'étape 76 est obtenu un mot décodé, noté :

[MATH 14]

$$\hat{C}' = (\hat{c}'_1, \ldots, \hat{c}'_N)$$

et un message correspondant, noté :

[MATH 15]

$$\hat{M}' = (\hat{m}'_1, \ldots, \hat{m}'_K)$$

Le mot décodé est une estimation du mot de code transmis multiplié par l'élément primitif $\alpha$ du corps $GF_q$ à la puissance k, k étant de décalage de synchronisation subi par le signal transmis :

[MATH 16]

$$\hat{C}' \simeq \left( \alpha^k c_1, \ldots, \alpha^k c_N \right)$$

De la même manière, le message décodé est une estimation du message M multiplié par l'élément primitif $\alpha$ du corps $GF_q$ à la puissance k

[MATH 17]

$$\hat{M}' \simeq \left( \alpha^k m_1, \ldots, \alpha^k m_K \right)$$

Le procédé comprend ensuite une étape 78 d'estimation du décalage de synchronisation k à partir du mot ou du message décodé, la valeur estimée du décalage de synchronisation étant notée $\hat{k}$.

Dans un mode de réalisation, l'estimation est effectuée connaissant la position prédéterminée et la valeur non-nulle prédéterminée du symbole ancrage du message M, introduit lors de l'étape 51 de formation du message M .

Par exemple, s'il s'agit du symbole position en première position, et la valeur non-nulle prédéterminée est égale à 1, c.-à-d., $m_1 = 1$, il en est déduit :

[MATH 18]

$$\widehat{m}_1' = \alpha^k$$

Par conséquent, l'estimation du décalage de synchronisation est calculée par la formule :

[MATH 19]

$$\hat{k} = \log_\alpha \widehat{m}_1'$$

où la fonction logarithmique ci-dessus dénote le logarithme discret définit dans le groupe multiplicatif du corps $GF_q$.

Dans un autre mode de réalisation, l'estimation est effectuée connaissant la position prédéterminée et la valeur non-nulle prédéterminée du symbole d'ancrage du mot de code C, introduit lors de l'étape 51 de formation du message M.

Par exemple, s'il s'agit du symbole position en première position, et la valeur non-nulle prédéterminée est égale à 1, c.-à-d., $c_1 = 1$, il en est déduit :

[MATH 20]

$$\hat{c}_1' = \alpha^k$$

Par conséquent, l'estimation du décalage de synchronisation est calculée par la formule :

[MATH 21]

$$\hat{k} = \log_\alpha \hat{c}_1'$$

Le procédé comporte ensuite un estimation 80 du mot de code C transmis et/ou du message $M$ correspondant, en appliquant le décalage de synchronisation $\hat{k}$ estimé.

L'étape 80 met en œuvre un calcul consistant à diviser chaque symbole du mot décodé $\hat{C}$ et/ou du message $\hat{M}'$ par l'élément primitif $\alpha$ du corps GFq à la puissance $\hat{k}$.

Ainsi, en dénotant par $\hat{C} = (\hat{c}_1, \dots, \hat{c}_N)$ l'estimation du mot de code transmis C, et par $\hat{M} = (\hat{m}_1, \dots, \hat{m}_K)$ l'estimation du message M correspondant, à l'étape 80 on détermine :

[MATH 22]

$$\hat{c}_i = \alpha^{-\hat{k}}\hat{c}_i', \qquad \forall i = 1, \dots, N$$

$$\widehat{m}_i = \alpha^{-\hat{k}}\widehat{m}_i', \qquad \forall i = 1, \dots, K$$

Optionnellement, si le mot décodé $\hat{C}$ à l'étape 80 n'est pas un mot de code, c'est-à-dire qu'il ne fait pas partie de l'ensemble des mots de code du code correcteur d'erreur mis en œuvre, le procédé comprend en plus une étape 82 de synchronisation du signal reçu en appliquant le décalage de synchronisation estimé $\hat{k}$, et les étapes 72 à 80 sont itérées jusqu'à ce qu'un critère d'arrêt soit vérifié.

Le critère d'arrêt consiste par exemple à vérifier que le mot décodé à l'étape 80 est un mot de code, ou qu'un nombre prédéterminé d'itérations a été effectué.

De plus, selon une variante, les étapes 70 à 82 sont appliquées périodiquement, avec une période égale à un nombre de bribes prédéterminé $\overline{k}$.

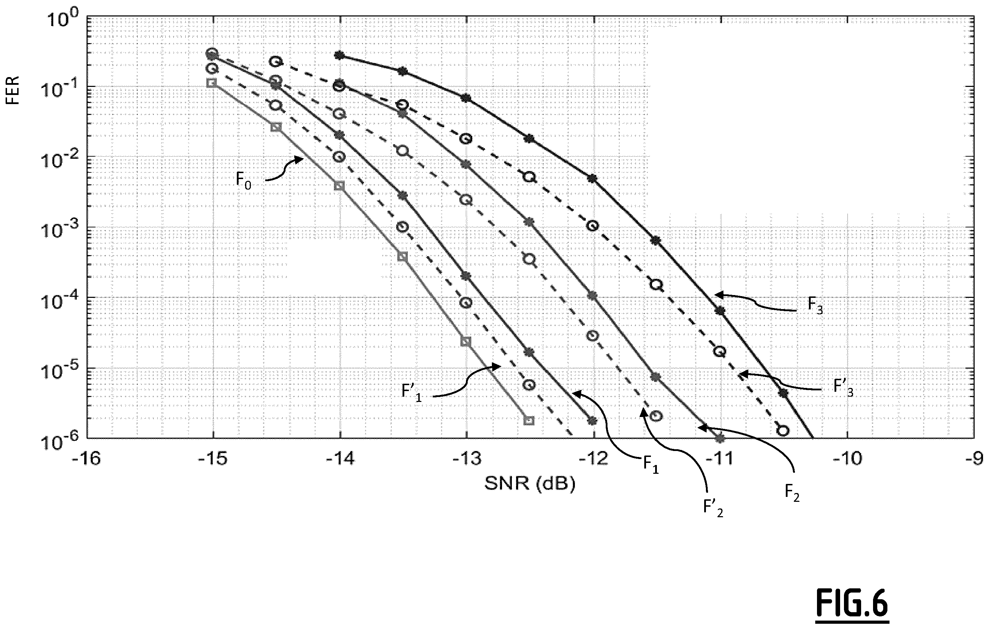

La **figure 6** illustre la performance de décodage dans un exemple pratique dans lequel p=6, q=64. Le code correcteur d'erreur non binaire utilisé est le code NB-LDPC sur $GF_{64}$, avec des nœuds de variable de degré 2 et des nœuds de parité de degré 3, et un rendement R=1/3.

Le message à transmettre comprend 20 symboles source de $GF_{64}$ (correspondant à K×p=120 bits source), incluant le symbole d'ancrage. Le mot de code généré par le codage LDPC non binaire contient N=60 symboles de $GF_{64}$.

Les symboles de mot de code sont modulés selon la première modulation CCSK modifiées, pour obtenir 60 séquences de q-1 =63 bribes, soit une trame de 3780 bribes. La séquence constante Z est une séquence « tout à zéro ».

La modulation BPSK est appliquée aux séquences de bribes, y compris la séquence Z, selon le schéma de modulation : 0->1 et 1->-1.

Le signal obtenu est bruité par un bruit blanc Gaussien de variance $\sigma^2$ pour simuler le canal de transmission.

Les courbes de résultat sont tracées dans le plan du taux d'erreur par trame en réception FER (pour « Frame Error Rate ») en fonction du rapport signal à bruit SNR.

La courbe $F_0$ correspond au cas sans décalage de synchronisation (k=0).

Les courbes $F_1$, $F'_1$ correspondent à un décalage de synchronisation inférieur ou égal à 4, le décodage étant répété périodiquement toutes les $\bar{k}$ = 8 bribes. La courbe $F_1$ en trait plein correspond au résultat après la première application du décodage conjoint avec l'estimation de décalage de synchronisation, et la courbe $F_1$' en traits pointillés correspond au résultat après l'application du décodage conjoint avec l'estimation de décalage de synchronisation avec une itération supplémentaire.

Les courbes $F_2$, $F'_2$ correspondent à un décalage de synchronisation inférieur ou égal à 10, le décodage étant répété périodiquement tous les $\bar{k}$ = 20 bribes, respectivement la courbe $F_2$ en trait plein correspond au résultat après la première application du décodage conjoint avec l'estimation de décalage de synchronisation, et la courbe $F_2$' en traits pointillés correspond au résultat après l'application du décodage conjoint avec l'estimation de décalage de synchronisation avec une itération supplémentaire.

Les courbes $F_3$, $F'_3$ correspondent à un décalage de synchronisation inférieur ou égal à 15, le décodage étant répété périodiquement tous les $\bar{k}$ = 30 bribes, respectivement la courbe $F_3$ en trait plein correspond au résultat après la première application du décodage conjoint avec l'estimation de décalage de synchronisation, et la courbe $F_3$' en traits pointillés correspond au résultat après l'application du décodage conjoint avec l'estimation de décalage de synchronisation avec une itération supplémentaire.

Selon une variante de réalisation, la formation du message M se fait de manière à déterminer « partiellement » la valeur d'un symbole d'ancrage placé à une position prédéterminée soit dans le message M, soit dans le mot de code C, cette valeur appartenant à un sous-ensemble prédéterminé de $GF_q$, de cardinal supérieur à 1.

On note également que si le symbole d'ancrage prend une valeur dans un sous-ensemble prédéterminé de $2^a$ éléments de GFq, avec $a < p$, le message *M* comporte alors *(K - 1)p + a* bits utiles.

Dans ce cas, à l'étape 78 on pourra déterminer plusieurs estimations du décalage de synchronisation. Précisément, une estimation du décalage de synchronisation peut être obtenue pour chaque valeur possible du symbole d'ancrage. On pourra ensuite choisir une parmi les estimations du décalage de synchronisation, en utilisant par exemple un critère de vraisemblance, ou une connaissance a priori de l'intervalle du décalage de synchronisation.

Par exemple, lorsque les étapes 70 à 82 sont appliquées périodiquement, avec une période égale à un nombre de bribes prédéterminé $\bar{k}$, alors on en déduit comme information a priori que le décalage de synchronisation $k \in \left[ -\dfrac{\bar{k}}{2}, +\dfrac{\bar{k}}{2} \right]$. Si une seule des estimations obtenues tombe dans cet intervalle, on pourra alors déterminer avec précision la valeur du décalage de synchronisation.

Dans tous les modes de réalisations décrits précédemment, la séquence de bribes Z, associée au symbole 0 de $GF_q$, est une séquence constante formée de q-1 bribes de même valeur, et donc invariante par tout décalage circulaire (ou permutation circulaire).

Selon une variante de réalisation, la séquence de bribes Z est invariante uniquement par un sous-ensemble prédéterminé de permutations correspondant à des décalages circulaires.

Dans cette variante, la séquence de bribes Z est dite partiellement invariante.

A titre d'exemple, si la séquence de bribes Z est invariante par les permutations correspondant aux décalages circulaires par un nombre pair de positions, alors Z aura la forme :

[MATH 23]

$$Z = (z, z', z, z', \dots)$$

Si la séquence de bribes Z est invariante par les permutations correspondant aux décalages circulaires par un nombre positions multiple de 3, alors Z aura la forme :

[MATH 24]

$$Z = (z, z', z'', z, z', z'', \dots)$$

Cela permet d'appliquer toutes les étapes de l'invention, comme décrites précédemment, en en particulier les étapes 70 à 82, en considérant plusieurs hypothèses sur le décalage de synchronisation, jusqu'à ce qu'à ce que la différence entre l'hypothèse considérée et le vrai décalage de synchronisation introduit par le canal corresponde à une permutation du sous-ensemble prédéterminé.

A titre d'exemple, si la séquence de bribes Z est invariante par les permutations correspondant aux décalages circulaires par un nombre pair de positions, on pourra considérer deux hypothèses, une première hypothèse considérant que le décalage de synchronisation est pair, et une deuxième hypothèse considérant que le décalage de synchronisation est impair.

Si la séquence de bribes Z est invariante par les permutations correspondant aux décalages circulaires par un nombre positions multiple de 3, on pourra considérer trois hypothèses, considérant respectivement que le décalage de synchronisation est un multiple de trois, un multiple de trois plus un, ou un multiple de trois plus deux.

Avantageusement, le procédé proposé, permet de détecter la présence d'un message. Avantageusement, lorsque le message est formé de sorte qu'un symbole d'ancrage soit placé à une position prédéterminé, le procédé permet de déterminer en outre le décalage de synchronisation, et par conséquent de réaliser conjointement la synchronisation et le décodage correcteur d'erreur après réception.

La détection de présence d'un message présente en intérêt en soi pour certaines applications.

De plus, dans le cas d'un message transmis protégé par un code correcteur CRC (pour « cyclic redundancy check »), il est envisageable de déterminer le décalage de synchronisation en testant toutes les valeurs possibles.

**Revendications**

1. Procédé de transmission de symboles de mots de code correcteur d'erreur non binaire à travers un canal de transmission (8), chaque symbole de mot de code comprenant p bits et faisant partie d'un corps fini $GF_q$ à $q=2^p$ éléments, le procédé comportant :

   - une première modulation (56) à étalement de spectre associant à chaque symbole de mot de code de p bits une séquence de bribes,
   - une deuxième modulation (66) pour moduler au moins une porteuse avec les séquences associées aux mots de code, par modulation de phase ou d'amplitude, permettant d'obtenir au moins une porteuse modulée,
   - une transmission de ladite au moins une porteuse modulée formant un signal à travers ledit canal de transmission (8),
   où la première modulation (56) met en œuvre un ensemble de q séquences comprenant q-1 séquences de q-1 bribes, chaque séquence étant obtenue par décalage circulaire d'une séquence pseudo-aléatoire de base ($R_0$), et une séquence partiellement invariante, formée de q-1 bribes et invariante par un sous-ensemble prédéterminé de décalages circulaires,
   et la première modulation (56) met en oeuvre en outre une association (64) entre chaque symbole de mot de code et une séquence de l'ensemble de séquences dans laquelle, ledit corps fini $GF_q$ ayant un élément primitif non nul, le symbole zéro est associé à ladite séquence partiellement invariante et un symbole égal à une puissance j de l'élément primitif, j étant un entier compris entre 0 et q-2, est associé à une séquence pseudo-aléatoire déterminée par j décalages circulaires de la séquence pseudo-aléatoire de base ($R_0$).

2. Procédé selon la revendication 1, dans lequel ladite séquence partiellement invariante est une séquence constante formée de q-1 bribes de même valeur.

3. Procédé selon la revendication 1 ou 2, comportant en outre, préalablement à l'application d'un code correcteur d'erreur non binaire, une formation (51) d'un message de K symboles de $GF_q$, auquel est appliqué le codage correcteur d'erreur non binaire pour générer un mot de code, le message étant formé (51) de sorte qu'un symbole dit symbole d'ancrage, de valeur appartenant à un sous-ensemble prédéterminé de $GF_q$, soit placé à une position prédéterminée dans le message ou dans ledit mot de code.

4. Procédé selon la revendication 3, dans lequel ledit sous-ensemble prédéterminé comprend une seule valeur non nulle prédéterminée, et ledit symbole d'ancrage prend ladite valeur non nulle prédéterminée.

5. Procédé selon la revendication 4, dans lequel dans l'étape de formation du message (51), ledit symbole d'ancrage est placé à ladite position prédéterminée dans le message.

6. Procédé selon la revendication 4, dans lequel la formation (51) du message comprend une détermination d'un symbole dudit message en fonction de K-1 autres symboles du message, le mot de code obtenu après codage comprenant ledit symbole d'ancrage à ladite position prédéterminée.

7. Procédé de transmission selon l'une des revendications 1 à 6, dans lequel la première modulation (56) comporte une génération (60) de la séquence pseudo-aléatoire de base ($R_0$) par un registre à décalage à rétroaction linéaire de longueur maximale.

8. Procédé de transmission selon l'une des revendications 1 à 7, dans lequel la deuxième modulation (66) est une modulation de phase ou d'amplitude de la porteuse.

9. Procédé de transmission selon l'une des revendications 1 à 8, dans lequel la deuxième modulation utilisée pour la séquence partiellement invariante est différente de la deuxième modulation utilisée par les séquences obtenues par décalage circulaire de la séquence pseudo-aléatoire de base ($R_0$).

10. Procédé de transmission selon la revendication 9, dans lequel la deuxième modulation comporte une absence d'onde porteuse pour la séquence partiellement invariante et une modulation de phase pour les séquences obtenues par décalage circulaire de la séquence pseudo-aléatoire de base ($R_0$).

11. Procédé de réception d'un signal reçu, ledit signal reçu étant issu d'un signal transmis par un procédé de transmission conforme aux revendications 1 à 10, ledit signal transmis comportant des symboles de mot de code correcteur d'erreur transmis, le procédé de réception étant **caractérisé en ce qu'**il comporte des étapes de :

- démodulation (72) du signal reçu, permettant d'obtenir une estimation des symboles codés transmis à partir du signal reçu,
- un décodage et synchronisation conjoints (74), comprenant :

- un décodage (76) pour déterminer un mot décodé et/ou un message décodé correspondant à partir des estimations de symboles codés fournies par l'étape de démodulation, ledit mot décodé fournissant une estimation du mot de code transmis multiplié par l'élément primitif du corps fini $GF_q$ élevé à une puissance égale à un décalage de synchronisation,
- une estimation (78) dudit décalage de synchronisation à partir d'un symbole d'ancrage à une position prédéterminée dans le mot décodé ou dans le message décodé correspondant.

12. Procédé de réception selon la revendication 11, comprenant en outre une estimation (80) du mot de code transmis en divisant les symboles du mot décodé et/ou du message décodé par l'élément primitif du corps fini élevé à la puissance égale au décalage de synchronisation estimé.

13. Procédé de réception selon la revendication 12, comprenant en outre, lorsque l'estimation (80) du mot de code transmis ne permet pas d'obtenir un mot de code, une synchronisation (82) en appliquant le décalage de synchronisation estimé et une itération des étapes de décodage (76), d'estimation (78) du décalage de synchronisation jusqu'à ce qu'un critère d'arrêt soit vérifié.

14. Procédé de réception selon l'une des revendications 11 à 13, dans lequel les étapes de démodulation (72) et de décodage et synchronisation conjoints (74) sont répétées périodiquement, en décalant le signal reçu d'un nombre de bribes prédéterminé.

15. Dispositif de transmission de symboles de mots de code correcteur d'erreur non binaire à travers un canal de transmission (8), chaque symbole de mot de code comprenant p bits et faisant partie d'un corps fini $GF_q$ à $q=2^p$ éléments, le dispositif de transmission étant configuré pour mettre en oeuvre :

- un module (14) de première modulation à étalement de spectre associant à chaque symbole de mot de code de p bits une séquence de bribes,

- un module (16) de deuxième modulation configuré pour moduler au moins une porteuse avec les séquences associées aux mots de code, par modulation de phase ou d'amplitude, permettant d'obtenir au moins une porteuse modulée,

- un module de transmission de ladite au moins une porteuse modulée formant un signal à travers ledit canal de transmission (8),

où le module (14) de première modulation est configuré pour mettre en oeuvre un ensemble de q séquences comprenant q-1 séquences de q-1 bribes, chaque séquence étant obtenue par décalage circulaire d'une séquence pseudo-aléatoire de base ($R_0$), et une séquence partiellement invariante, formée de q-1 bribes et invariante par un sous-ensemble prédéterminé de décalages circulaires,

et le module (14) de première modulation est en outre configuré pour mettre en oeuvre une association entre chaque symbole de mot de code et une séquence de l'ensemble de séquences dans laquelle, ledit corps fini $GF_q$ ayant un élément primitif non nul, le symbole zéro est associé à la séquence partiellement invariante et un symbole égal à une puissance j de l'élément primitif, j étant un entier compris entre 0 et q-2, est associé à une séquence pseudo-aléatoire déterminée par j décalages circulaires de la séquence pseudo-aléatoire de base ($R_0$).

16. Dispositif de réception d'un signal reçu, ledit signal reçu étant issu d'un signal transmis par un dispositif de transmission selon la revendication 15, ledit signal transmis comportant des symboles de mot de code correcteur d'erreur transmis, le dispositif de réception étant configuré pour mettre en oeuvre :

- un module (20) de démodulation du signal reçu, permettant d'obtenir une estimation des symboles codés transmis à partir du signal reçu,
- un module (22) de décodage et synchronisation conjoints, comprenant :

- un module (24) de décodage pour déterminer un mot décodé et/ou un message décodé correspondant à partir des estimations de symboles codés fournies par l'étape de démodulation, ledit mot décodé fournissant une estimation du mot de code transmis multiplié par l'élément primitif du corps fini $GF_q$ élevé à une puissance égale à un décalage de synchronisation,
- un module (26) d'estimation dudit décalage de synchronisation à partir d'un symbole d'ancrage à une position prédéterminée dans le mot décodé ou dans le message décodé correspondant.

**Patentansprüche**

1. Übertragungsverfahren von nicht-binären Fehlerkorrekturcode-Wortsymbolen über einen Übertragungskanal (8), wobei jedes Codewortsymbol p Bits umfasst und Teil eines endlichen Körpers $GF_q$ mit $q=2^p$ Elementen ist, das Verfahren umfassend:

eine erste Modulation (56) mit Spektrumspreizung, die mit jedem Codewortsymbol aus p Bits eine Abfolge von Fragmenten assoziiert,

eine zweite Modulation (66) zum Modulieren mindestens eines Trägers mit den Sequenzen, die mit den Codewörtern assoziiert sind, durch Phasen- oder Amplitudenmodulation, was es ermöglicht, mindestens einen modulierten Träger zu erlangen,

eine Übertragung des mindestens einen modulierten, signalbildenden Trägers über den Übertragungskanal (8), wobei die erste Modulation (56) einen Satz von q Sequenzen implementiert, der q-1 Sequenzen von q-1 Fragmenten umfasst, wobei jede Sequenz durch zirkulären Versatz einer Basis-Pseudozufallssequenz ($R_0$) erlangt wird, und eine teilweise invariante Sequenz, die aus q-1 Fragmenten gebildet ist und durch eine vorbestimmte Untermenge von zirkulären Versätzen invariant ist,

und die erste Modulation (56) ferner eine Assoziation (64) zwischen jedem Codewortsymbol und einer Sequenz aus dem Satz von Sequenzen implementiert, wobei der endliche Körper $GF_q$ ein primitives Element ungleich Null ist, wobei das Symbol Null mit der teilweise invarianten Sequenz assoziiert ist, und ein Symbol gleich wie eine Potenz j des primitiven Elements aufweist, wobei j eine ganze Zahl zwischen 0 und q-2 ist, mit einer Pseudozufallssequenz verbunden ist, die durch j zirkuläre Versätze der Basis-Pseudozufallssequenz ($R_0$) bestimmt wird.

2. Verfahren nach Anspruch 1, wobei die teilweise invariante Sequenz eine konstante Sequenz ist, die aus q-1 Fragmenten mit demselben Wert gebildet ist.

3. Verfahren nach Anspruch 1 oder 2, ferner umfassend, vor der Anwendung eines nicht-binären Fehlerkorrekturcodes, ein Bilden (51) einer Nachricht aus K Symbolen von $GF_q$, auf die die nicht-binäre Fehlerkorrekturcodierung angewendet wird, um ein Codewort zu erzeugen, wobei die Nachricht gebildet wird (51), sodass ein als Ankersymbol bezeichnetes Symbol mit einem Wert, der zu einer vorbestimmten Untermenge von $GF_q$ gehört, an einer vorbestimmten Position in der Nachricht oder in dem Codewort platziert wird.

4. Verfahren nach Anspruch 3, wobei die vorbestimmte Teilmenge einen einzelnen vorbestimmten Wert ungleich null umfasst, und das Verankerungssymbol den vorbestimmten Wert ungleich null annimmt.

5. Verfahren nach Anspruch 4, wobei das Verankerungssymbol in dem Schritt eines Bildens der Nachricht (51) an der vorbestimmten Position in der Nachricht platziert wird.

6. Verfahren nach Anspruch 4, wobei das Bilden (51) der Nachricht eine Bestimmung eines Symbols der Nachricht abhängig von K-1 anderen Symbolen der Nachricht umfasst, das nach der Codierung erlangte Codewort umfassend das Ankersymbol an der vorbestimmten Position.

7. Übertragungsverfahren nach einem der Ansprüche 1 bis 6, wobei die erste Modulation (56) eine Erzeugung (60) der Basis-Pseudozufallssequenz ($R_0$) durch ein linear rückgekoppeltes Versatzregister mit maximaler Länge umfasst.

8. Übertragungsverfahren nach einem der Ansprüche 1 bis 7, wobei die zweite Modulation (66) eine Phasen- oder Amplitudenmodulation des Trägers ist.

9. Übertragungsverfahren nach einem der Ansprüche 1 bis 8, wobei die zweite Modulation, die für die teilweise invariante Sequenz verwendet wird, sich von der zweiten Modulation unterscheidet, die von den Sequenzen verwendet wird, die durch zirkulären Versatz der Basis-Pseudozufallssequenz ($R_0$) erlangt werden.

10. Übertragungsverfahren nach Anspruch 9, wobei die zweite Modulation ein Fehlen einer Trägerwelle für die teilweise invariante Sequenz und eine Phasenmodulation für die Sequenzen umfasst, die durch zirkulären Versatz der Basis-Pseudozufallssequenz ($R_0$) erlangt werden.

11. Empfangsverfahren eines empfangenen Signals, wobei das empfangene Signal aus einem Signal stammt, das durch ein Übertragungsverfahren nach den Ansprüchen 1 bis 10 übertragen wird, wobei das übertragene Signal übertragene Fehlerkorrekturcode-Wortsymbole umfasst, wobei das Empfangsverfahren **dadurch gekennzeichnet ist, dass** es die folgenden Schritte umfasst:

- Demodulation (72) des empfangenen Signals, was es ermöglicht, eine Schätzung der übertragenen codierten Symbole anhand des empfangenen Signals zu erlangen,
- eine gemeinsame Decodierung und Synchronisation (74), umfassend:

- eine Decodierung (76), um ein decodiertes Wort und/oder eine entsprechende decodierte Nachricht anhand der Schätzungen der codierten Symbole zu bestimmen, die von dem Demodulationsschritt bereitgestellt werden, wobei das decodierte Wort eine Schätzung des übertragenen Codeworts bereitstellt, das mit dem primitiven Element des finiten Körpers $GF_q$ multipliziert wird, das auf eine Potenz gleich wie ein Synchronisationsversatz erhöht wird,
- eine Schätzung (78) des Synchronisationsversatzes anhand eines Ankersymbols an einer vorbestimmten Position in dem decodierten Wort oder in der entsprechenden decodierten Nachricht.

12. Empfangsverfahren nach Anspruch 11, ferner umfassend eine Schätzung (80) des übertragenen Codeworts durch Teilen der Symbole des decodierten Worts und/oder der decodierten Nachricht durch das primitive Element des endlichen Körpers, das mit der gleichen Potenz wie der geschätzte Synchronisationsversatz erhöht wird.

13. Empfangsverfahren nach Anspruch 12, ferner umfassend, wenn es die Schätzung (80) des übertragenen Codeworts nicht ermöglicht, ein Codewort zu erlangen, eine Synchronisation (82) durch Anwenden des geschätzten Synchronisationsversatzes und eine Iteration der Schritte des Decodierens (76), Schätzens (78) des Synchronisationsversatzes, bis ein Stoppkriterium verifiziert wird.

14. Empfangsverfahren nach einem der Ansprüche 11 bis 13, wobei die Schritte der gemeinsamen Demodulation (72) und Decodierung und Synchronisation (74) periodisch wiederholt werden, wobei das empfangene Signal um eine vorbestimmte Anzahl von Fragmenten versetzt ist.

15. Übertragungsvorrichtung von nicht-binären Fehlerkorrekturcode-Wortsymbolen über einen Übertragungskanal (8), wobei jedes Codewortsymbol p Bits umfasst und Teil eines endlichen Körpers $GF_q$ mit $q=2^p$ Elementen ist, wobei die Übertragungsvorrichtung konfiguriert ist, um Folgendes zu implementieren:

- ein Modul (14) einer ersten Modulation mit Spektrumspreizung, die mit jedem Codewortsymbol aus p Bits eine Abfolge von Fragmenten assoziiert,
- ein Modul (16) einer zweiten Modulation, das konfiguriert ist, um mindestens einen Träger mit den Sequenzen, die mit den Codewörtern assoziiert sind, durch Phasen- oder Amplitudenmodulation zu modulieren, was es ermöglicht, mindestens einen modulierten Träger zu erlangen,
- ein Modul zur Übertragung des mindestens einen modulierten, signalbildenden Trägers durch den Übertragungskanal (8),

wobei das Modul (14) einer ersten Modulation konfiguriert ist, um einen Satz von q Sequenzen zu implementieren, der q-1 Sequenzen von q-1 Fragmenten umfasst, wobei jede Sequenz durch zirkulären Versatz einer Basis-Pseudozufallssequenz ($R_0$) erlangt wird, und eine teilweise invariante Sequenz, die aus q-1 Fragmenten gebildet ist und durch eine vorbestimmte Untermenge von zirkulären Versätzen invariant ist, und das Modul (14) einer ersten Modulation ferner konfiguriert ist, um eine Assoziation zwischen jedem Codewortsymbol und einer Sequenz aus dem Satz von Sequenzen zu implementieren, wobei der endliche Körper $GF_q$ ein primitives Element ungleich Null ist, wobei das Symbol Null mit der teilweise invarianten Sequenz assoziiert ist, und ein Symbol gleich wie eine Potenz j des primitiven Elements aufweist, wobei j eine ganze Zahl zwischen 0 und q-2 ist, mit einer Pseudozufallssequenz verbunden ist, die durch j zirkuläre Versätze der Basis-Pseudozufallssequenz ($R_0$) bestimmt wird.

16. Empfangsvorrichtung eines empfangenen Signals, wobei das empfangene Signal aus einem Signal stammt, das von einer Übertragungsvorrichtung nach Anspruch 15 übertragen wird, das übertragene Signal umfassend übertragene Fehlerkorrekturcode-Wortsymbole, wobei die Empfangsvorrichtung konfiguriert ist, um Folgendes zu implementieren:

- ein Modul (20) zur Demodulation des empfangenen Signals, was es ermöglicht, eine Schätzung der übertragenen codierten Symbole anhand des empfangenen Signals zu erlangen,
- ein Modul (22) zur gemeinsamen Decodierung und Synchronisation, umfassend:

- ein Modul (24) zur Decodierung, um ein decodiertes Wort und/oder eine entsprechende decodierte Nachricht anhand der Schätzungen der codierten Symbole zu bestimmen, die von dem Demodulationsschritt bereitgestellt werden, wobei das decodierte Wort eine Schätzung des übertragenen Codeworts bereitstellt, das mit dem primitiven Element des finiten Körpers $GF_q$ multipliziert wird, das auf eine Potenz gleich wie ein Synchronisationsversatz erhöht wird,
- ein Modul (26) zur Schätzung des Synchronisationsversatzes anhand eines Ankersymbols an einer vorbestimmten Position in dem decodierten Wort oder in der entsprechenden decodierten Nachricht.

**Claims**

1. A method for transmitting non-binary error correcting code word symbols through a transmission channel (8), each code word symbol comprising p bits and being part of a finite field $GF_q$ with $q=2^p$ elements, the method including:

- a first spread spectrum modulation (56) associating a sequence of chips with each p-bit code word symbol,
- a second modulation (66) for modulating at least one carrier with the sequences associated with the code words, by phase or amplitude modulation, making it possible to obtain at least one modulated carrier,
- a transmission of said at least one modulated carrier forming a signal through said transmission channel (8),

wherein the first modulation (56) implements a set of q sequences comprising q-1 sequences of q-1 chips, each sequence being obtained by circular shifting of a basic pseudo-random sequence ($R_0$), and a partially invariant sequence, consisting of q-1 chips and invariant to a predetermined subset of circular shifts, and the first modulation (56) further implements an association (64) between each code word symbol and a sequence of the set of sequences wherein, said finite field $GF_q$ has a non-zero primitive element, the symbol zero being associated with said partially invariant sequence and a symbol equal to a power j of the primitive element, j being an integer comprised between 0 and q-2, being associated with a pseudo-random sequence determined by j circular shifts of the basic pseudo-random sequence ($R_0$).

2. The method according to claim 1, wherein said partially invariant sequence is a constant sequence consisting of q-1 chips of the same value.

3. The method according to claim 1 or 2, further including, prior to the application of a non-binary error correcting code, the formation (51) of a message of K symbols of $GF_q$, to which the non-binary error correcting coding is applied so as to generate a code word, the message being formed (51) in such a way that a symbol called an anchoring symbol, with a value belonging to a predetermined subset of $GF_q$, is placed at a predetermined position in the message or in said code word.

4. The method according to claim 3, wherein said predetermined subset comprises a single predetermined non-zero value, and said anchoring symbol takes said predetermined non-zero value.

5. The method according to claim 4, wherein during the step of forming the message (51), said anchoring symbol is placed at said predetermined position in the message.

6. The method according to claim 4, wherein the formation (51) of the message comprises a determination of a symbol of said message as a function of K-1 other symbols of the message, the code word obtained after encoding comprising said anchoring symbol at said predetermined position.

7. Transmission method according to one of claims 1 to 6, wherein the first modulation (56) comprises the generation (60) of the basic pseudo-random sequence ($R_0$) by a linear feedback shift register of maximum length.

8. The transmission method according to one of claims 1 to 7, wherein the second modulation (66) is a phase or an amplitude modulation of the carrier.

9. The transmission method according to one of claims 1 to 8, wherein the second modulation used for the partially invariant sequence is different from the second modulation used by the sequences obtained by circular shifting of the basic pseudo-random sequence ($R_0$).

10. The transmission method according to claim 9, wherein the second modulation includes an absence of carrier wave for the partially invariant sequence and a phase modulation for the sequences obtained by circular shifting of the basic pseudo-random sequence ($R_0$).

11. A method for receiving a received signal, said received signal coming from a signal transmitted by a transmission method according to claims 1 to 10, said transmitted signal including transmitted error correcting code word symbols, the reception method being **characterized in that** same includes steps of:

    - demodulating (72) the received signal, which can be used for obtaining an estimation of the coded symbols transmitted from the received signal,
    - a joint decoding and synchronization (74), comprising:

        - a decoding (76) for determining a decoded word and/or a corresponding decoded message from the estimations of the coded symbols, as provided by the demodulation step, said decoded word providing an estimation of the transmitted code word multiplied by the primitive element of the finite field $GF_q$ raised to a power equal to a synchronization shift,
        - an estimation (78) of said synchronization shift starting from an anchoring symbol at a predetermined position in the decoded word or in the corresponding decoded message.

12. The reception method according to claim 11, further comprising an estimation (80) of the transmitted code word by dividing the symbols of the decoded word and/or of the decoded message by the primitive element of the finite field raised to the power equal to the estimated synchronization shift.

13. The reception method according to claim 12, further comprising, when the estimation (80) of the transmitted code word does cannot be used for obtaining a code word, a synchronization (82) by applying the estimated synchronization shift and an iteration of the decoding (76) steps, of estimation (78) of the synchronization shift until a stop criterion is satisfied.

14. The reception method according to one of claims 11 to 13, wherein the steps of demodulation (72) and of joint decoding and synchronization (74) are periodically repeated, shifting the received signal by a predetermined number of chips.

15. A device for transmitting non-binary error correcting code word symbols through a transmission channel (8), each code word symbol comprising p bits and being part of a finite field $GF_q$ with $q=2^p$ elements, the transmission device being configured for implementing:

> - a first spread spectrum modulation module (14) associating a sequence of chips with each p-bit code word symbol,
> - a second modulation module (16) configured for modulating of at least one carrier with the sequences associated with the code words, by phase or amplitude modulation, which can be used for obtaining at least one modulated carrier,
> - a module for transmitting said at least one modulated carrier forming a signal, through said transmission channel (8),

> > wherein the first modulation module (14) is configured for implementing a set of q sequences comprising q-1 sequences of q-1 chips, each sequence being obtained by circular shifting of a basic pseudo-random sequence ($R_0$), and a partially invariant sequence, consisting of q-1 chips and invariant to a predetermined subset of circular shifts,
> > and the first modulation module (14) is further configured for implementing an association between each code word symbol and a sequence of the set of sequences wherein, said finite field $GF_q$ having a non-zero primitive element, the symbol zero being associated with the partially invariant sequence and a symbol equal to a power j of the primitive element, j being an integer comprised between 0 and q-2, is associated with a pseudo-random sequence determined by j circular shifts of the basic pseudo-random sequence ($R_0$).

16. A device for receiving a received signal, said received signal being derived from a signal transmitted by a transmission device according to claim 15, said transmitted signal including transmitted error correcting code word symbols, the reception device being configured for implementing:

> - a module (20) for demodulating the received signal, which can be used for obtaining an estimation of the coded symbols transmitted from the received signal,
> - a module (22) for joint decoding and synchronization, comprising:

> > - a decoding module (24) for determining a decoded word and/or a corresponding decoded message from the estimations of the coded symbols, as provided by the demodulation step, said decoded word providing an estimation of the transmitted code word multiplied by the primitive element of the finite field $GF_q$ raised to a power equal to a synchronization shift,
> > - a module (26) for estimating said synchronization shift from an anchoring symbol at a predetermined position in the decoded word or in the corresponding decoded message.

FIG.1

FIG.2

**FIG.3**

Formation message M — 51

Codage NB — 52

50

$C = \{c_1, c_2, ... c_N\}$ — 54

Première modulation — 56

Obtention séquence de base $R_0$ — 58

Génération/mémorisation $R_1$ à $R_{q-2}$ — 60

Mémorisation mise en correspondance — 62

Association $c_j <- S_j$ — 64

Deuxième modulation — 66

Transmission — 68

**FIG.4**

FIG.5

Réception signal Y — 70

Démodulation — 72

74

Décodage NB — 76

Estimation décalage de synchronisation $\hat{k}$ — 78

Estimation mot de code $\{c_1,..,c_N\}$ — 80

Synchronisation avec $\hat{k}$ — 82

Décalage signal de $\overline{k}$ bribes — 84

FIG.6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2015003499 A1